# EUROPEAN PATENT APPLICATION

(11) **EP 2 879 175 A1**
(43) Date of publication of application: **03.06.2015**
(21) Application number: 14191965.4
(22) Date of filing: 05.11.2014
(51) Int. Cl.: H01L 25/16, H01L 25/065, H01L 25/10, H01L 23/498

(54) **Vertically connected integrated circuits**

(30) Priority: 27.11.2013 US 201314092310
(71) Applicant: Honeywell International Inc., Morristown, NJ 07962-2245 (US)
(72) Inventor: Jensen, Ronald J., Morristown, NJ New Jersey 07962-2245 (US)
(74) Representative: Houghton, Mark Phillip

(57) **Abstract**

In some examples, an integrated circuit (IC) includes a semiconductor substrate defining a perimeter of the integrated circuit and a castellation formed at the perimeter. The IC also may include a layer including an electrically conductive material formed on a surface of the castellation. In some examples, the layer including the electrically conductive material is not substantially parallel to adjacent portions of the perimeter of the IC. The integrated circuit may be used in a system, in which the metallized castellation may be used to electrically connect the IC to an external structure, such as another IC or a printed board.

## Description

### TECHNICAL FIELD

The present disclosure relates to integrated circuits.

### BACKGROUND

Three-dimensional integrated circuit (IC) structures in which a plurality of integrated circuits are stacked vertically and interconnected in the vertical direction perpendicular to the active surface of the ICs may be used to increase volumetric density and packaging efficiency for integrated circuits. Techniques for vertically interconnecting ICs include wire bonding to respective active surfaces of vertically stacked ICs, solder bump (flip chip) connections to active surfaces or backsides of respective ICs, mounting ICs on interposers which are vertically interconnected, and patterning traces on vertical faces of stacked ICs using laser patterning or thin film wafer processing.

Thru-silicon via (TSV) technology has emerged as a method for obtaining vertical electrical connections (vias) through a silicon substrate, permitting electrical connections between an active surface and a back side of an IC. TSVs may be formed using wafer-level IC processes to etch high-aspect ratio holes into (or through) a silicon substrate, fill the holes with metals (e.g. copper or tungsten), and thin the silicon substrate to expose the metallization on the bottom side of the substrate.

### SUMMARY

The present disclosure describes techniques for forming structures that facilitate vertical connection of stacked integrated circuits (ICs), ICs including such structures, systems including multiple, interconnected ICs, and techniques for forming the structures, ICs, and systems. In some examples, the structure that facilitates vertical connection of ICs includes a castellation formed at a perimeter of an IC. The castellation may include a layer including an electrically conductive material formed on the surface of the castellation, which provides a location for electrical connection of the IC to another IC or a printed board. In some examples, the castellation may be formed by forming a hole in a semiconductor wafer at a location corresponding to a saw street, where the semiconductor wafer will be singulated to form individual ICs. The hole may be metallized by depositing a layer including an electrically conductive material on the surface of the hole. Once the semiconductor substrate is singulated, the metallized castellation will be exposed at the perimeter of an IC. The metallized castellation may be used to make an electrical connection to an external device, such as another IC or a printed board.

In an example, the disclosure describes an integrated circuit including a semiconductor substrate defining a perimeter of the integrated circuit and a castellation formed at the perimeter. In accordance with this example, the integrated circuit also may include a layer including an electrically conductive material formed on a surface of the castellation. In some examples, the layer including the electrically conductive material is not substantially parallel to adjacent portions of the perimeter of the integrated circuit. The integrated circuit further may include an active area formed in the semiconductor substrate, where the active area comprises a plurality of active devices, and a connecting link electrically connecting the active area and the layer including the electrically conductive material.

In another example, the disclosure describes a system including an integrated circuit, a substrate, and a solder trace. The integrated circuit may include a semiconductor substrate defining a perimeter of the integrated circuit and a castellation formed at the perimeter. In accordance with this example, the integrated circuit also may include a layer including an electrically conductive material formed on a surface of the castellation. In some examples, the layer including the electrically conductive material is not substantially parallel to adjacent portions of the perimeter of the integrated circuit. The integrated circuit further may include an active area formed in the semiconductor substrate, where the active area comprises a plurality of active devices, and a connecting link electrically connecting the active area and the layer including the electrically conductive material. The integrated circuit may be mechanically attached to the substrate, and the substrate may include an electrical connection. The solder trace may electrically connect the electrical connection of the substrate and the layer including the electrically conductive material.

In a further example, the disclosure describes a method including forming a plurality of holes in a semiconductor wafer at locations corresponding to a saw street and metallizing respective walls of the plurality of holes to form respective layers including an electrically conductive material on the respective walls of the plurality of holes, where metallizing respective walls of the plurality of holes does not fill the holes with metal. In accordance with this example, the method also may include forming a plurality of active devices in the semiconductor substrate and electrically connecting the respective layers including the electrically conductive material to respective active devices of the plurality of active devices using a respective connecting link of a plurality of connecting links. Additionally, the method may include singulating the semiconductor wafer along the saw street to form a perimeter of the semiconductor substrate comprising a plurality of metallized castellations.

The details of one or more examples are set forth in the accompanying drawings and the description below. Other features, objects, and advantages will be apparent from the description and drawings, and from the claims.

### BRIEF DESCRIPTION OF DRAWINGS

FIG. 1 is a conceptual diagram illustrating a plan view of an example integrated circuit including a plurality of metallized castellations formed in a perimeter of the integrated circuit.
FIG. 2 is a plan view conceptual diagram illustrating a plan view of another example integrated circuit including a plurality of metallized castellations formed in a perimeter of the integrated circuit.
FIG. 3 is a conceptual diagram illustrating a plan view of an example semiconductor substrate including a plurality of active areas and a plurality of metallized vias formed at locations corresponding to saw streets.
FIG. 4 is a conceptual diagram illustrating a plan view of another example semiconductor substrate including a plurality of active areas and a plurality of metallized vias formed at locations corresponding to saw streets.
FIG. 5 is a flow diagram illustrating an example technique for forming an integrated circuit including a plurality of metallized castellations formed in a perimeter of the integrated circuit.
FIG. 6 is flow diagram illustrating another example technique for forming an integrated circuit including a plurality of metallized castellations formed in a perimeter of the integrated circuit.
FIG. 7 is flow diagram illustrating another example technique for forming an integrated circuit including a plurality of metallized castellations formed in a perimeter of the integrated circuit.
FIGS. 8A and 8B are schematic and conceptual diagrams illustrating an example system including a stack including a plurality of integrated circuits.
FIGS. 9A and 9B are schematic and conceptual diagrams illustrating an example system including a stack including a plurality of integrated circuits.

### DETAILED DESCRIPTION

The present disclosure describes techniques for forming structures that facilitate vertical connection of stacked integrated circuits (ICs), ICs including such structures, systems including multiple, interconnected ICs, and techniques for forming the structures, ICs, and systems. In some examples, the structures that facilitate vertical connection of ICs include a castellation formed in a perimeter of an IC. The castellation may include a layer including an electrically conductive material formed on the surface of the castellation, which provides a location for electrical connection of the IC to another IC or a printed board.

In some examples, the castellation may be formed by forming a hole in a semiconductor wafer at a location corresponding to a saw street, where the semiconductor wafer will be singulated to form individual ICs. The hole may be metallized by depositing layer including an electrically conductive material, such as an electrically conductive metal or alloy, on the surface of the hole. Once the semiconductor substrate is singulated, the metallized castellation will be exposed at the perimeter of an IC.

Because the metallized castellation is located at a perimeter of the IC, the metallized castellation may facilitate electrical connection between the IC and an electrical connection external to the IC. The electrical connection external to the IC may be on a substrate, such as another IC or a printed board. For example, a plurality of ICs may be stacked, and the metallized castellation on one or more of the ICs may facilitate electrical connection between the IC including the metallized castellation and another of the ICs and/or a printed board. In some examples, solder may be used to electrically connect the metallized castellation to the external electrical connection. Because the castellation defines a surface that is not substantially parallel to adjacent portions of the perimeter of the IC (e.g., a curved surface in at least one plane), the castellations may facilitate an effective solder connection. Additionally, in some examples, a solder connection may be more resistant to ageing and/or fatigue under thermal cycling than a connection made with a conductive adhesive, and may be more cost-effective than forming an electrical connection between two ICs using laser patterning or lithography of a deposited metal film, or electroless plating.

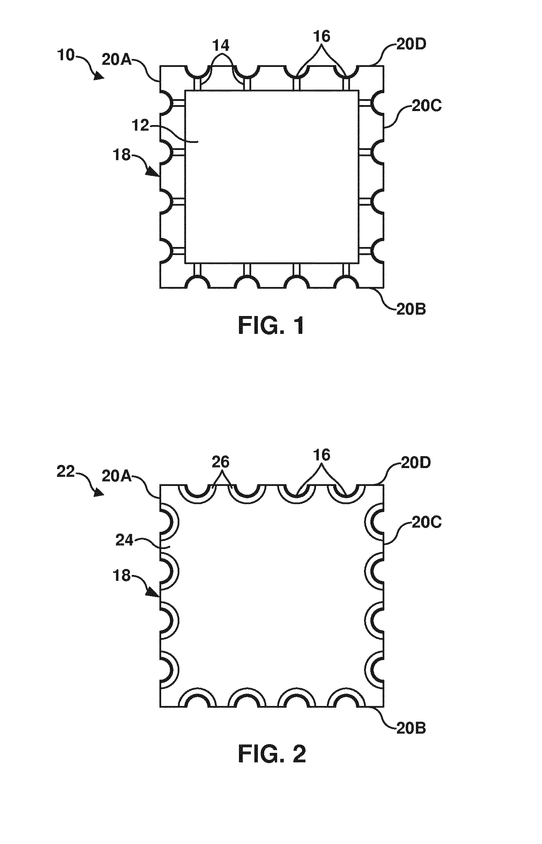

FIG. 1 is a conceptual diagram illustrating a plan view of an example IC 10 including a plurality of metallized castellations 16 formed at a perimeter of the IC. Although the example illustrated in FIG. 1 includes a plurality of metallized castellations 16, in other examples, IC 10 may include more or fewer metallized castellations 16. In general, IC 10 may include a metallized castellation 16 or at least one metallized castellation 16. IC 10 includes an active area 12, a plurality of connecting links 14, and a plurality of metallized castellations 16. IC 10 defines a perimeter 18, and the plurality of metallized castellations 16 are formed at perimeter 18. IC 10 may be formed on bulk silicon, silicon-on-insulator technology, or other semiconductor material technology.

Active area 12 includes the active devices of IC 10, including a plurality of transistors, resistors, capacitors, or the like. The active devices provide the functionality of IC 10, such as a processor, memory device, or the like. The plurality of connecting links 14 electrically connect the respective ones of the active devices to respective ones of the plurality of metallized castellations 16 to enable electrical communication between the active devices and the respective ones of the plurality of metallized castellations 16. In some examples, the plurality of connecting links 14 may be formed of electrically conductive metal traces formed on a surface of IC 10 or in a layer or multiple layers within IC 10, as described below.

The plurality of metallized castellations 16 may include a layer including an electrically conductive material, such as an electrically conductive metal. The electrically conductive metal may include, for example, copper (Cu), nickel (Ni), or the like, or alloys including Cu and another metal, Ni and another metal, or the like. As described below, the plurality of metallized castellations 16 may be formed in IC 10 by first forming the shape of the castellations in IC 10, followed by forming the layer including an electrically conductive material, such as an electrically conductive metal or alloy, on the respective surface of the respective castellations.

The plurality of metallized castellations 16 deviate from the general shape of perimeter 18. For example, in the example shown in FIG. 1, perimeter 18 is generally square and includes generally planar surfaces 20A-20D (collectively, "generally planar surfaces 20"). Each of the plurality of metallized castellations 16 defines a respective recess in the generally planar surfaces 20. Because the layer including an electrically conductive material may approximately reproduce the curvature of the castellations and do not fill the volume of the recesses defined by the castellations, the layers including the electrically conductive material on the respective surfaces of the respective castellations are not co-planar with the generally planar surface 20. This may facilitate use of solder to form an electrical connection between one of the plurality of metallized castellations 16 and a structure external to IC 10, such as a metallized castellation on another IC or a bond pad on a printed circuit board to which IC 10 is attached, as the metallized castellations 16 may provide additional surface area for the solder to connect to compared to a planar metalized structure that would be formed on a surface of planar surfaces 20. Additionally, the metallized castellations 16 introduce additional volume in which solder may be deposited, which may improve fatigue characteristics under thermal cycling of the electrical connection between IC 10 and another external device (e.g., another IC 10 or a printed board).

In some examples, in addition to including a layer including an electrically conductive material at the metallized castellations 16, an IC may include one or more metallized bond pads formed on a top surface of the IC. FIG. 2 is a plan view conceptual diagram illustrating another example IC 22 including a plurality of metallized castellations 16 formed in a perimeter 18 of the IC 22. Similar to IC 10 of FIG. 1, IC 22 of FIG. 2 includes a plurality of metallized castellations 16 formed in a perimeter 18 of IC 22, and the perimeter is defined by generally planar surfaces 20A-20D. Also similar to IC 10 of FIG. 1, IC 22 may include more or fewer metallized castellations 16, such as a metallized castellation 16 or at least one metallized castellation 16. Although not shown in FIG. 2, IC 22 includes an active area 12 that includes a plurality of active devices and a plurality of connecting links 14 electrically connecting the plurality of active devices to respective ones of the plurality of metallized castellations 16.

Unlike IC 10. IC 22 includes a plurality of bond pads 26. Respective ones of the plurality of bond pads 26 are formed adjacent to and electrically connected to respective ones of the plurality of metallized castellations 16. In some examples, as shown in FIG. 2, the plurality of bond pads 26 may each define an annular or semi-annular shape extending about at least a portion of a respective one of metallized castellations 16. In other examples, the plurality of bond pads 26 may define a different shape, and each of bond pads 26 may define the same shape or at least one of bond pads 26 may define a different shape than at least one other of bond pads 26. Additionally or alternatively, at least one bond pad of the plurality of bond pads 26 may extend along less than the entire perimeter defined by a respective one of metallized castellations 16.

The plurality of bond pads 26 may be formed on top surface 24 of IC 22. In some examples, in addition to or as an alternative to including the plurality of bond pads 26 formed on top surface 24, IC 22 may include a plurality of bond pads formed on a bottom surface (substantially opposite to top surface 24) of IC 22. When IC 22 is stacked with at least one other IC, one or both top surface 24 and a bottom surface of IC 22 are adjacent to another IC in order to define a vertical stack of ICs. In some examples, although not shown in FIG. 2, respective ones of the plurality of annular bond pads 26 may be electrically connected to respective ones of the plurality of connecting links (not shown in FIG. 2). The plurality of bond pads 26 may include an electrically conductive metal or alloy, such as, for example, copper (Cu), nickel (Ni), or the like, or alloys including Cu and another metal, Ni and another metal, or the like. The plurality of annular bond pads 26 may further increase an area to which solder may be flowed, and thus may improve reliability of a solder connection to metallized castellations 16.

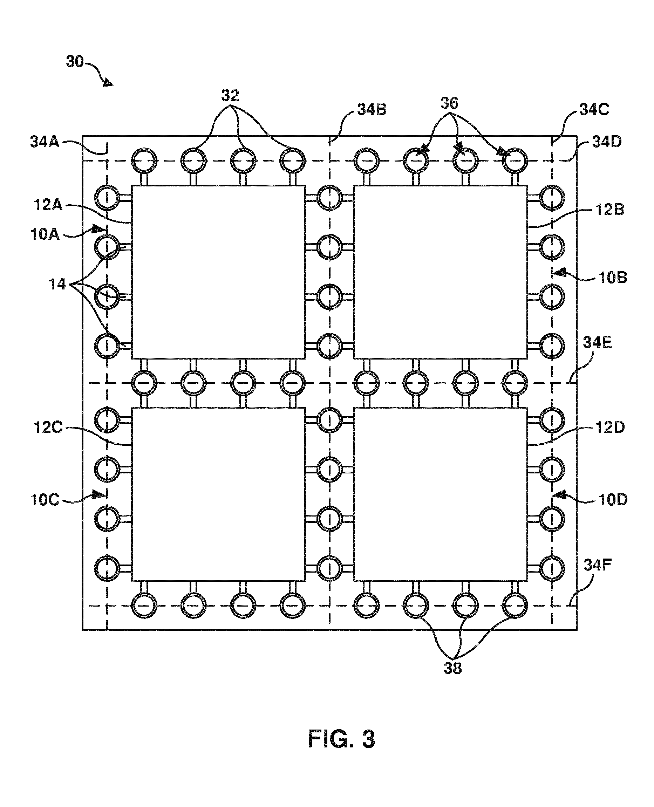

In some examples, the metallized castellations 16 may be formed in parallel (e.g., during the same fabrication step) in a plurality of ICs. FIG. 3 is a conceptual diagram illustrating a plan view of an example semiconductor wafer 30 including a plurality of active areas 12A-12D (collectively, "active areas 12") and a plurality of metallized vias 32 formed at locations corresponding to saw streets 34A-34F (collectively, "saw streets 34"). In the example shown in FIG. 3, semiconductor wafer 30 includes four active areas 12, which, when separated, will form parts of four ICs 10A-10D (collectively, "ICs 10"). However, the number of active areas 12 and, after separation, ICs 10, in FIG. 3 is merely an example, and in other implementations, a semiconductor wafer 30 may include tens, hundreds, thousands, or the like of active areas 12 and, after separation, ICs 10. Additionally or alternatively, although FIG. 3 illustrates semiconductor wafer 30 as defining a square shape, in other examples, semiconductor wafer 30 may define another shape, such as circle, ellipse, or the like.

As shown in FIG. 3, each of metallized vias 32 are formed at a location at which semiconductor wafer 30 will be singulated (e.g., separated or cut) when forming ICs 10. In particular, metallized vias 32 are located such that, when semiconductor wafer 30 is singulated along saw streets 34, metallized vias 32 will be exposed, and a structure similar to IC 10 of FIG. 1 will be formed. In this way, metallized vias 32 may be formed during processing of semiconductor wafer 30, e.g., as part of the processing of semiconductor wafer 30 on the wafer level to form active areas 12 and connecting links 14 and prior to forming individual ICs 10 from semiconductor wafer 30. This ability to form metallized vias 32 during processing of semiconductor wafer 30 and before separation of wafer 30 into individual ICs 10 may be more efficient than forming metallized castellation in a single IC 10 at a time, e.g., due to the parallelization allowed by wafer-level processing.

In the example of FIG. 3, each of the metallized vias 32 is defined by a respective hole 36 defined by semiconductor wafer 30, and the walls of the respective holes 36 are covered by a layer 38 including an electrically conductive material, such as an electrically conductive metal or alloy. In some examples, holes 36 extend through the entire thickness of semiconductor wafer 30 from a top surface of wafer 30 to a bottom surface of wafer 30. In other examples, holes 36 extend partially through the thickness of semiconductor wafer 30, e.g., from a first surface of wafer 30 to an intermediate depth of wafer 30, but do not extend fully through wafer. Later, material may be removed from wafer 30, e.g., by etching or grinding, to reduce a thickness of wafer 30 and result in the hole 36 extending through the thickness of wafer 30.

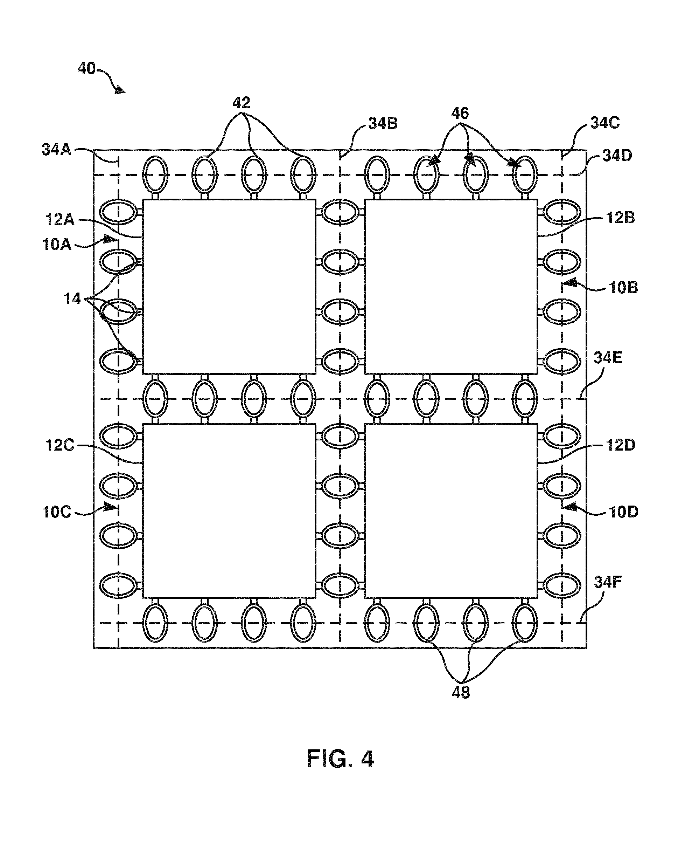

Each of metallized vias 32 also defines a substantially circular cross-sectional shape in the plane of FIG. 3. In other examples, metallized vias 32 may define a different cross-sectional shape in the plane of FIG. 3. For example, FIG. 4 is a conceptual diagram illustrating another example semiconductor wafer 40 including a plurality of active areas 12 and a plurality of metallized vias 42 formed at locations corresponding to saw streets 34. In contrast to the example semiconductor wafer 30 illustrated in FIG. 3, semiconductor wafer 40 of FIG. 4 includes metallized vias 42 that define an elliptical or oval cross-section in the plane of FIG. 4. The cross-sectional shapes of metallized vias 32 and 42 illustrated in FIGS. 3 and 4, respectively, are examples, and other cross-sectional shapes may also be used for metallized vias 32 and 42. Each of metallized vias 42 is defined by an elliptically-shaped hole 46 in semiconductor wafer 40, and includes a layer 48 including an electrically conductive material formed on the wall of the respective elliptically-shaped holes 46.

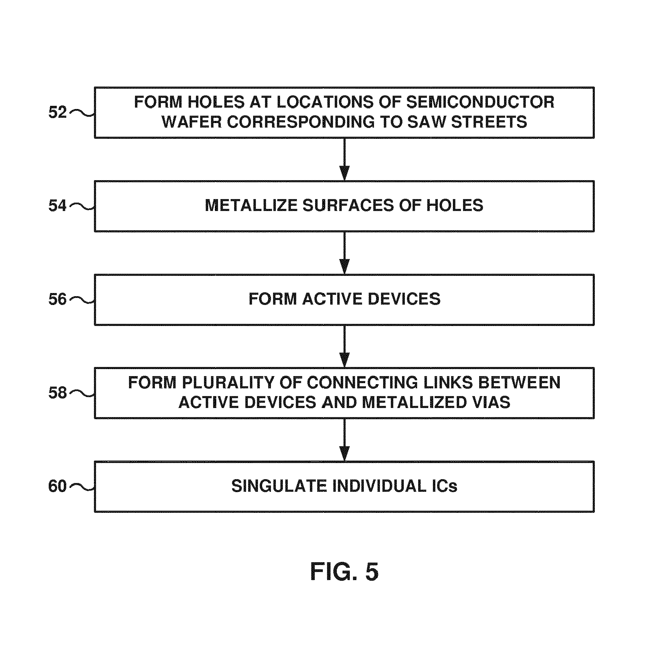

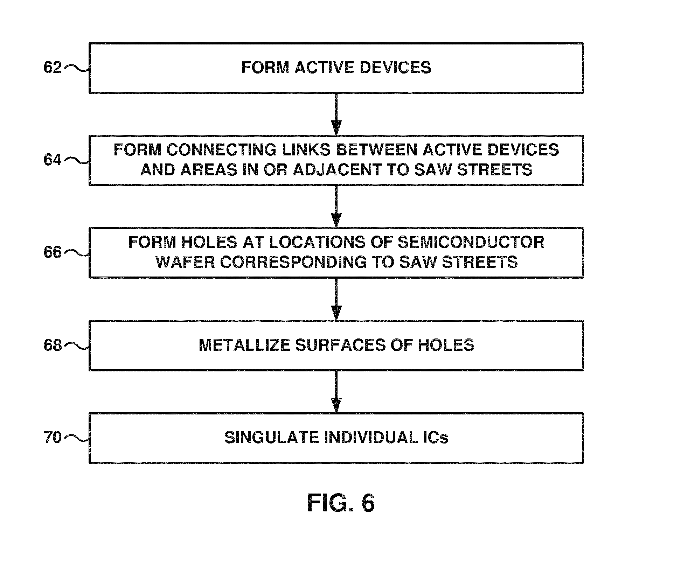

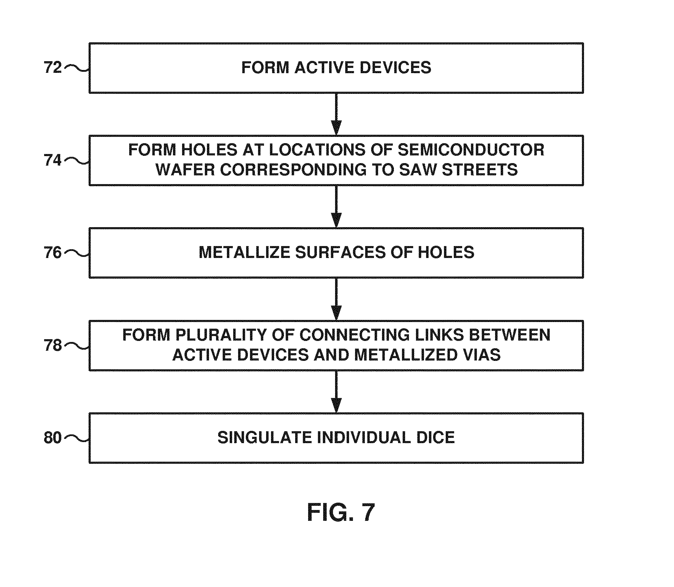

ICs including a metallized castellation may be formed by any of a variety of techniques. Some example techniques are illustrated in FIGS. 5-7. FIG. 5 is a flow diagram illustrating an example technique for forming an IC including a plurality of metallized castellations formed at a perimeter of the IC. The technique of FIG. 5 will be described with respect to IC 10 illustrated in FIG. 1 and the example semiconductor wafer 30 illustrated in FIG. 3. In other examples, the technique of FIG. 5 may be used to form other ICs, e.g., IC 22 of FIG. 2. Additionally, techniques other than that depicted in FIG. 5 may be used to form IC 10 (e.g., including, but not limited to, the techniques depicted in FIGS. 6 and 7). Although the example technique illustrated in FIG. 5 describes forming a plurality of metallized castellations, the technique may be used to form any number of metallized castellations, including a single metallized castellation or at least one metallized castellation.

The technique of FIG. 5 may be referred to as a through-silicon via (TSV) first technique, and includes forming a plurality of holes 36 at locations of semiconductor wafer 30 corresponding to saw streets 34 (52). For example, the plurality of holes 36 may be formed using one or more photolithographic processes, such as depositing a photoresist on a surface of semiconductor wafer 30, developing the photoresist to define locations of the plurality of holes 36, and selectively etching the plurality of holes 36, e.g., using deep reactive ion etching (DRIE).

In some examples, forming the plurality of holes 36 at locations of semiconductor wafer 30 corresponding to saw streets 34 (52) may include forming the plurality of holes 36 to extend through the entire thickness of semiconductor wafer 30, e.g., from a first, top surface of semiconductor wafer 30 to a second, bottom surface of semiconductor wafer 30 on an opposite side of wafer 30 from the top surface. In other examples, forming the plurality of holes 36 at locations of semiconductor wafer 30 corresponding to saw streets 34 (52) may include forming the plurality of holes 36 to extend through a partial thickness of semiconductor wafer 30, such that the plurality of holes 36 stop before reaching the bottom surface of semiconductor wafer 30. In some of these examples, a portion of semiconductor wafer 30 may later be removed (e.g., using grinding, polishing, or etching) to thin semiconductor wafer 30 and result in the plurality of holes 36 extending through the thickness of semiconductor wafer 30.

In some examples, after singulation, a distance between a first side of the surface of a respective one of holes 36 and a second side of the surface of the respective one of holes 36, measured along the plane of the respective one of generally planar surfaces 20 in which the holes 36 are formed, may be between about 10 micrometers (µm) and about 20 µm (e.g., a diameter of the respective one of holes 36 may be between about 10 µm and about 20 µm). In examples in which the holes 36 define a substantially circular shape (e.g., circular or nearly circular), the distance from the first side of the surface to the second side of the surface may be a diameter of the hole. However, in other examples, the distance between the first side of the surface of the respective one of holes 36 and the second side of the surface of the respective one of holes 36, measured along the plane of the respective one of generally planar surfaces 20 in which the holes 36 are formed may be less than about 10 µm or greater than about 20 µm. Additionally or alternatively, the size of holes 36 may be the same, or the size of at least one of holes 36 may be different than the size of at least one other of holes 36.

In some examples, a distance between similar points of adjacent holes 36 (e.g., respective centers of adjacent holes 36) may be between about 25 µm and about 50 µm. However, in other examples, the distance between similar points of adjacent holes 36 may be less than about 25 µm or greater than about 50 µm. Additionally or alternatively, the distance between similar points of adjacent holes 36 may be the same, or the distance between similar points of two adjacent holes 36 may be different than the distance between similar points of two other adjacent holes 36.

The technique of FIG. 5 also includes metallizing the respective surfaces of the plurality of holes 36 to form metallized vias 32 (54). In some examples, metallizing the respective surfaces of the plurality of holes 36 (54) may include depositing a layer 38 including an electrically conductive material on the respective surfaces of the plurality of holes 36. For example, the layer 38 including the electrically conductive material may be deposited by one or more deposition processes such as sputtering, electroplating, or the like.

In some examples, metallizing the respective surfaces of the plurality of holes 36 (54) may include forming a single layer of electrically conductive material on the respective surfaces of the plurality of holes 36. The electrically conductive material may include, for example, copper (Cu), nickel (Ni), or the like, or alloys including Cu and another metal, Ni and another metal, or the like.

In other examples, metallizing the respective surfaces of the plurality of holes 36 (54) may include forming multiple layers of material on the respective surfaces of the plurality of holes 36. For example, metallizing the respective surfaces of the plurality of holes 36 (54) may include forming a dielectric layer on the respective surfaces of the plurality of holes 36 using, e.g., silicon dioxide (SiO₂), and forming a seed layer or adhesion layer on the respective dielectric layers using a deposition process such as sputtering. In some examples, the seed layer may include an adhesion metal, such as titanium (Ti), tantalum (Ta), a titanium-tungsten (Ti/W) alloy, or the like. In some of these examples, metallizing the respective surfaces of the plurality of holes 36 (54) may include forming a layer of solderable metal on the seed layer using a deposition process such as sputtering. The solderable metal may include, for example, Cu, Ni, an alloy including at least one of Cu or Ni, or the like. In some examples, metallizing the respective surfaces of the plurality of holes 36 (54) may further include forming an oxidation barrier layer. The oxidation barrier layer may include an electrically conductive and oxidation-resistant material, such as gold (Au).

Regardless of the technique used for metallizing the respective surfaces of the plurality of holes 36 (54), the electrically conductive material(s) (e.g., metal layer(s)) deposited on the respective surfaces of the plurality of holes 36 does not fill the volumes of the respective holes of the plurality of holes 36. By not filling the volumes of the respective holes of the plurality of holes 36, when semiconductor wafer 30 is singulated, layer 38 including the electrically conductive material may not be substantially coplanar with the perimeter of the respective IC 10 (e.g., as described with respect to FIG. 1). In some examples, an outer surface of layer 38 including the electrically conductive material may substantially reproduce (e.g., reproduce or nearly reproduce) a curvature of the wall of the respective one of the plurality of holes 38.

In some examples, layer 38 including an electrically conductive material may define a thickness (e.g., measured in a direction extending away from IC 10) of between about 1 µm and about 5 µm. In other examples, layer 38 including an electrically conductive material may define a thickness of greater than about 5 µm or less than about 1 µm. Additionally or alternatively, the thickness of layer 38 including an electrically conductive material may be about the same for each of metallized vias 32, or the thickness of layer 38 including an electrically conductive material for a first one of metallized vias 32 may be different than that thickness of layer 38 including an electrically conductive material for a second one of metallized vias 32.

The technique of FIG. 5 also includes forming active devices in the respective active areas 12 of semiconductor wafer 30 (56). The active devices may be formed using known semiconductor processing techniques, including, for example, those used in front-end-of-line (FEOL) processing.

The technique of FIG. 5 also includes forming a plurality of connecting links 14 connecting respective active areas 12 to metallized vias 32 (58). In the technique of FIG. 5, the plurality of connecting links 14 may be formed during back-end-of-line (BEOL) processing of semiconductor wafer 30. In BEOL processing, individual devices in active areas 12 are interconnected using metal interconnects (e.g., Cu or Al), and dielectric layers (e.g., silicon dioxide) are deposited to electrically insulate respective metal interconnects from other metal interconnects. The plurality of connecting links 14 may be formed between respective ones of some of the active devices in respective active areas 12 and respective ones of metallized vias 32 at one or more layers within semiconductor wafer 30, e.g., at one or more levels of the metal interconnects, with dielectric layers underlying and overlying the respective ones of the plurality of connecting links 14. In some examples, at least one of metallized vias 32 may not be connected to the respective active area 12 of the respective one of ICs 10 using a respective one of connecting links 14. This may allow more routing options for electrical signals to and from respective ones of ICs 10.

After formation of the metallized vias 32, active areas 12, and plurality of connecting links 14, semiconductor wafer 30 may be singulated to form individual ICs 10 (60). In some examples, semiconductor wafer 30 may be singulated by cutting or sawing semiconductor wafer 30 along saw streets 34. When semiconductor wafer 30 is singulated to form ICs 10, the metallized vias 32 cut approximately through their center, exposing layer 38 including an electrically conductive material. This results in the structure shown in FIGS. 1 and 2, in which metallized castellations 16 are present at the perimeter of IC 10.

In the technique of FIG. 5, the plurality of holes 36 and metallized vias 32 are formed prior to forming active devices in active areas 12. In other examples, the plurality of holes 36 and metallized vias 32 may be formed at a different point in the process of forming ICs 10. FIG. 6 is flow diagram illustrating another example technique for forming an IC 10 including a plurality of metallized castellations 16 formed at a perimeter of the IC. The technique of FIG. 6 will be described with respect to the IC 10 illustrated in FIG. 1 and the example semiconductor wafer 30 illustrated in FIG. 3. In other examples, the technique of FIG. 6 may be used to form other ICs, e.g., IC 22 of FIG. 2. Although the example technique illustrated in FIG. 6 describes forming a plurality of metallized castellations 16, the technique may be used to form any number of metallized castellations 16, including a metallized castellation 16 or at least one metallized castellation 16.

The technique illustrated in FIG. 6 may be referred to as a TSV last process, as the plurality of holes 36 and metallized vias 32 are formed after the FEOL processing and during the BEOL of processing, after the plurality of connecting links 14 have been formed extending from respective ones of active areas 12 to locations near saw streets 34.

The technique of FIG. 6 includes forming active devices in respective active areas 12 of semiconductor wafer 30 (62). The active devices may be formed using known semiconductor processing techniques, including, for example, those used in front-end-of-line (FEOL) processing.

The technique of FIG. 6 also includes forming a plurality of connecting links 14 extending between respective active areas 12 and areas in or adjacent to saw streets 34 (64). In the technique of FIG. 6, the plurality of connecting links 14 may be formed during back-end-of-line (BEOL) processing of semiconductor wafer 30. In BEOL processing, individual devices in active areas 12 are interconnected using metal interconnects (e.g., Cu or Al), and dielectric layers (e.g., silicon dioxide) are deposited to electrically insulate respective metal interconnects from other metal interconnects. The plurality of connecting links 14 may be formed between respective ones of some of the active devices in respective active areas 12 and areas in or adjacent to saw streets 34 at one or more layers within semiconductor wafer 30, e.g., at one or more levels of the metal interconnects, with dielectric layers underlying and overlying the respective ones of the plurality of connecting links 14.

The technique of FIG. 6 also includes forming a plurality of holes 36 at locations of semiconductor wafer 30 corresponding to saw streets 34 adjacent to and/or partially overlapping respective ones of the plurality of connecting links 14 (66). For example, the plurality of holes 36 may be formed using one or more photolithographic processes, such as depositing photoresist on a surface of semiconductor wafer 30, developing the photoresist to define locations of the plurality of holes 36, and selectively etching the plurality of holes 36, e.g., using DRIE

As described above with respect to FIG. 5, in some examples, forming the plurality of holes 36 at locations of semiconductor wafer 30 corresponding to saw streets 34 (52) may include forming the plurality of holes 36 to extend through the entire thickness of semiconductor wafer 30. In other examples, forming the plurality of holes 36 at locations of semiconductor wafer 30 corresponding to saw streets 34 (52) may include forming the plurality of holes 36 to extend through a partial thickness of semiconductor wafer 30, such that the plurality of holes 36 stop before reaching the bottom surface of semiconductor wafer 30.

The technique of FIG. 6 also includes metallizing the respective surfaces of the plurality of holes 36 to form metallized vias 32 (68). The metallization step (68) of FIG. 6 may be same as or substantially similar to the metallization step (54) described with respect to FIG. 5.

After formation of the metallized vias 32, active areas 12, and plurality of connecting links 14, semiconductor wafer 30 may be singulated to form individual ICs 10 (70). In some examples, semiconductor wafer 30 may be singulated by cutting or sawing semiconductor wafer 30 along saw streets 34. When semiconductor wafer 30 is singulated to form ICs 10, the metallized vias 32 cut approximately through their center, exposing layer 38 including an electrically conductive material. This results in the structures shown in FIGS. 1 and 2, in which metallized castellations 16 are present at the perimeter of IC 10.

In other examples, rather than forming metallized vias 32 prior to the formation of active devices in active areas 12 or towards the end of BEOL processing, metallized vias 32 may be formed between FEOL and BEOL processing. FIG. 7 is flow diagram illustrating another example technique for forming an IC including a plurality of metallized castellations formed in a perimeter of the IC. The technique of FIG. 7 will be described with respect to the IC 10 illustrated in FIG. 1 and the example semiconductor wafer 30 illustrated in FIG. 3. In other examples, the technique of FIG. 7 may be used to form other ICs, e.g., IC 22 of FIG. 2. Although the example technique illustrated in FIG. 6 describes forming a plurality of metallized castellations 16, the technique may be used to form any number of metallized castellations 16, including a metallized castellation 16 or at least one metallized castellation 16.

The technique of FIG. 7 includes forming active devices in respective active areas 12 of semiconductor wafer 30 (72). The active devices may be formed using known semiconductor processing techniques, including, for example, those used in FEOL processing.

The technique of FIG. 7 also includes forming a plurality of holes 36 at locations of semiconductor wafer 30 corresponding to saw streets 34 (74). In some examples, the plurality of holes 36 may be formed in semiconductor wafer 30 using a technique similar to or substantially the same as one or more of those described with respect to step (52) of FIG. 5.

The technique of FIG. 7 further includes metallizing the respective surfaces of the plurality of holes 36 to form metallized vias 32 (76). In some examples, metallizing the respective surfaces of the plurality of holes 36 (76) may include depositing a layer including an electrically conductive material on the respective surfaces of the plurality of holes 36. For example, the layer including the electrically conductive material may be deposited by one or more deposition processes such as sputtering, electroplating, or the like. In some examples, the technique used to metallize the respective surface of the plurality of holes 36 (76) may be the similar to or substantially the same as one or more of those described with respect to step (54) of FIG. 5.

Metallizing the respective surfaces of the plurality of holes 36 to form metallized vias 32 (76) may be performed as part of the BEOL processing. Additionally, the technique of FIG. 7 may include forming a plurality of connecting links 14 extending between respective active areas 12 and respective ones of metallized vias 32 (78). In the technique of FIG. 7, the plurality of connecting links 14 may be formed during BEOL processing of semiconductor wafer 30. In BEOL processing, individual devices in active areas 12 are interconnected using metal interconnects (e.g., Cu or Al), and dielectric layers (e.g., silicon dioxide) are deposited to electrically insulate respective metal interconnects from other metal interconnects. The plurality of connecting links 14 may be formed between respective ones of some of the active devices in respective active areas 12 and respective ones of metallized vias 32 at one or more layers within semiconductor wafer 30, e.g., at one or more levels of the metal interconnects, with dielectric layers underlying and overlying the respective ones of the plurality of connecting links 14. In some examples, at least one of metallized vias 32 may not be connected to the respective active area 12 of the respective one of ICs 10 using a respective one of connecting links 14. This may allow more routing options for electrical signals to and from respective ones of ICs 10.

After formation of the metallized vias 32, active areas 12, and plurality of connecting links 14, semiconductor wafer 30 may be singulated to form individual ICs 10 (80). In some examples, semiconductor wafer 30 may be singulated by cutting or sawing semiconductor wafer 30 along saw streets 34. When semiconductor wafer 30 is singulated to form ICs 10, the metallized vias 32 cut approximately through their center, exposing layer 38 including an electrically conductive material. This results in the structures shown in FIGS. 1 and 2, in which metallized castellations 16 are present at the perimeter of IC 10.

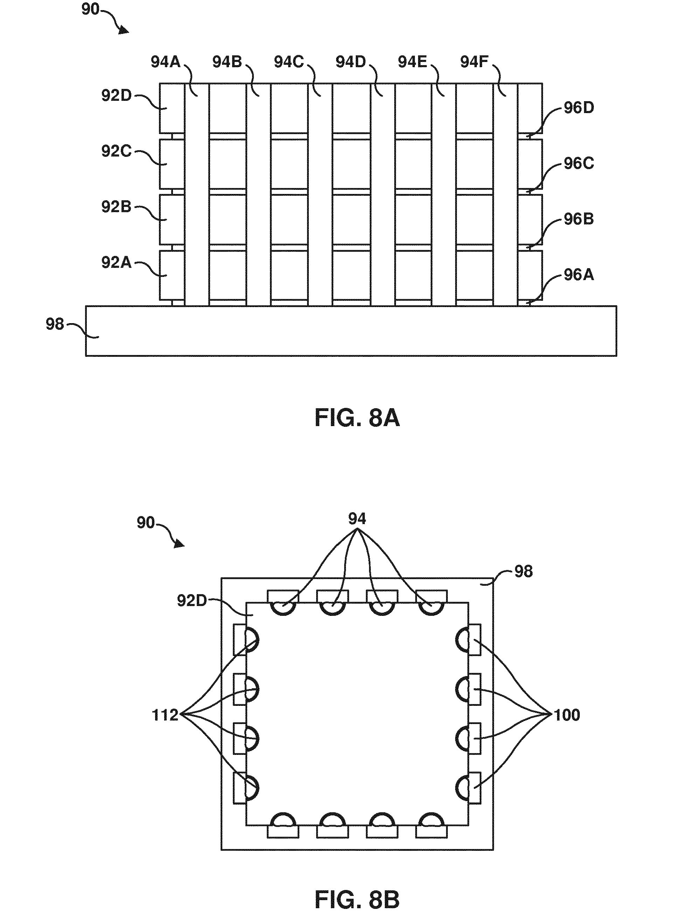

In some examples, the ICs 10 and 22 illustrated in FIGS. 1 and 2 and formed by one or more of the techniques illustrated in FIGS. 5-7 may be vertically stacked and electrically interconnected using metallized castellations 16. FIGS. 8A and 8B are schematic and conceptual diagrams illustrating an example system including a stack including a plurality of ICs.

As shown in the example of FIGS. 8A and 8B, a system 90 may include first IC 92A, second IC 92B, third IC 92C, and fourth IC 92D (collectively, "ICs 92"). ICs 92 are directly or indirectly electrically and mechanically coupled to a substrate 98, which may include, for example, a printed board, an IC, or another type of substrate. As shown in FIG. 8B, in some examples, substrate 98 may include electrical connections, such as bond pads 100, to which ICs 92 are electrically connected, e.g., using solder traces 94A-94F (collectively, "solder traces 94"). In other examples, substrate 98 may not include electrical connections.

FIG. 8A illustrates an example including four ICs 92. In other examples, system 90 may include more than four ICs 92 or fewer than four ICs 92. Generally, system 90 may include at least one ICs 92. Each of ICs 92 may be similar to or substantially the same (e.g., the same or nearly the same) as one of ICs 10 or 22.

ICs 92 are vertically stacked, with fourth IC 92D disposed over third IC 92C, which is disposed over second IC 92B, which is disposed over first IC 92A. In the example of FIGS. 8A and 8B, each of ICs 92 is adhered to adjacent ICs 92 using a respective layer of thermally conductive adhesive 96A-96D (collectively, "thermally conductive adhesive layers 96"). For example a top surface of third IC 92C is adhered to a bottom surface of fourth IC 92D, a bottom surface of third IC 92C is adhered to a top surface of second IC 92B, a bottom surface of second IC 92B is adhered to a top surface of first IC 92A, and a bottom surface of first IC 92A is adhered to a top surface of substrate 98. The thermally conductive adhesive layers 96 may mechanically join adjacent ones of ICs 92, and may also provide a thermal pathway for dissipating heat generated during operation of ICs 92. The thermally conductive adhesive layers 96 may include, for example, a thermally conductive epoxy or cyanate ester adhesive.

In other examples, each of ICs 92 may be attached to adjacent ICs 92 using a respective layer of underfill. In other examples, each of ICs 92 may be attached to adjacent one of ICs 92 using only the solder, and may include an air gap between surfaces of the adjacent ICs.

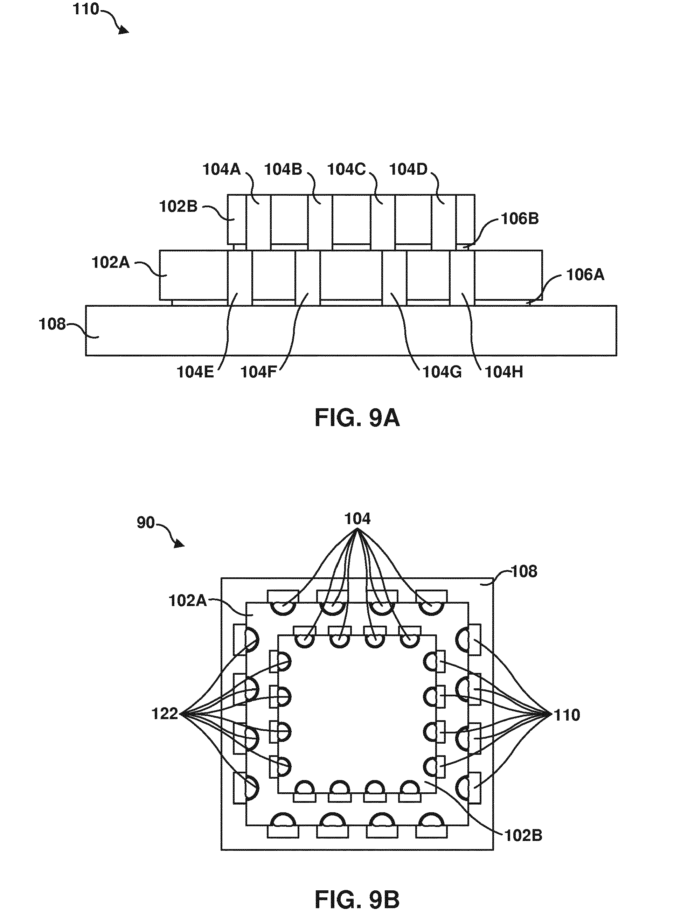

In the example illustrated in FIGS. 8A and 8B, each of ICs 92 is substantially the same size and shape (e.g., the same size and shape or nearly the same size and/or shape). In other examples, as described below with respect to FIGS. 9A and 9B, at least one of ICs 92 may be a different size and/or shape than at least one other of ICs 92. Additionally, in the example illustrated in FIG. 8A and 8B, metallized castellations 16 of each of ICs 92 are substantially aligned (e.g., aligned or nearly aligned) in the vertical direction of FIG. 8A. This may result in solder traces 94 being oriented in a substantially vertical (e.g., vertical or nearly vertical) direction, as shown in FIG. 8A.

Solder traces 94 electrically connect respective metallized castellations 16 of respective ones of ICs 92 with other respective metallized castellations 16 of other respective ones of ICs 92 and/or with bond pads 100 formed on the surface of substrate 98. In general, solder traces 94 may connect a respective metallized castellation of metallized castellations 16 with an external electrical connection formed on a substrate, which may be a respective metallized castellation 16 formed on another one of ICs 92 and/or may be a bond pad 100 formed on substrate 98.

In some examples, in the configuration illustrated in FIG. 8A, first solder trace 94A is configured to conduct electrical signals to and from one of bond pads 100, first IC 92A, second IC 92B, third IC 92C, and fourth IC 92D in parallel using respective metallized castellations on first IC 92A, second IC 92B, third IC 92C, and fourth IC 92D. Similarly, second solder trace 94B, third solder trace 94C, fourth solder trace 94D, fifth solder trace 94E, and sixth solder trace 94F may be configured to conduct electrical signals to and from substrate 98, first IC 92A, second IC 92B, third IC 92C, and fourth IC 92D in parallel using a respective one of bond pads 100 on substrate 98 and respective metallized castellations on first IC 92A, second IC 92B, third IC 92C, and fourth IC 92D.

In other examples, at least one of ICs 92 may include at least one metallized castellation 16 may not be connected to the respective active area of the respective one of ICs 92 using a respective one of connecting links 14 (FIG. 1). Hence, the electrical signals conducted by the solder trace 94 passing over that castellation may not be conducted to the active devices of that IC. This may allow more routing options for electrical signals to and from respective ones of ICs 92.

Solder traces 94 are formed by solder after ICs 92 are mechanically attached, e.g., using thermally conductive adhesive layers 96. Solder traces 94 may be formed using any suitable soldering process, including, for example, solder jetting. In solder jetting, spheres of solder are ejected through a capillary and impinged upon with a laser upon ejection from the capillary. Heat from the laser melts the solder spheres to form a solder jet. Solder jetting may allow precise control over the location at which solder is deposited and the amount (e.g., volume) of solder that is deposited at each location.

Because metallized castellations 16 define a curved surface and are not substantially coplanar with the planar walls of the perimeters of the ICs 92 (see, e.g., FIG. 1), metallized castellations 16 may facilitate a stronger solder joint compared to a planar soldering surface. This is believed to be due to the surface tension of the solder, which may cause solder to contract towards a minimal surface area. The curvature of metallized castellations 16 thus may more closely follow the curvature of the solder due to surface tension compared to a planar soldering surface, and may improve the bond between the solder and the metallized castellation 16 compared to a bond between solder and a planar surface. Additionally, curvature of metallized castellations 16 may allow use of more solder compared to a planar soldering surface, which may also contribute to improved thermal cycling fatigue characteristics of the solder joint.

Although the example illustrated in FIGS. 8A and 8B includes ICs 92 having substantially the same size and shape, in other examples, the techniques described herein may be applied to ICs having different sizes and/or shapes. FIGS. 9A and 9B are schematic and conceptual diagrams illustrating an example system including a stack including a plurality of integrated circuits. Similar to the example illustrated in FIGS. 8A and 8B, system 110 includes a substrate 108, such as a printed board, an IC, or another type of substrate. System 110 also includes a first IC 102A and a second IC 102B (collectively, "ICs 102"). Each of ICs 102 may be similar to or substantially the same as one of ICs 10 or 22 illustrated in FIGS. 1 and 2. As shown in FIG. 9B, each of ICs 102 includes a plurality of metallized castellations 122.

Unlike system 90, in system 110, ICs 102 define different sizes. For example, second IC 102B is smaller than first IC 102A. Second IC 102B is stacked vertically above first IC 102A, and is mechanically attached to first IC 102A using a layer of thermally conductive adhesive 106B. First IC 102A is attached to a surface of substrate 108 using a layer of thermally conductive adhesive 106A.

In other examples, each of ICs 102 may be attached to adjacent ICs 102 (and substrate 108) using a respective layer of underfill. In other examples, each of ICs 102 may be attached to adjacent one of ICs 102 using only the solder, and may include an air gap between surfaces of the adjacent ICs.

As shown in FIG. 9B, substrate 108 and first IC 102A each include a plurality of bond pads 110 defined on surface of substrate 108 and first IC 102A, respectively. Respective metallized castellations 122 of second IC 102B are electrically connected to respective bond pads 110 on first IC 102A using respective solder traces 104A, B, C, D. Respective metallized castellations 122 of first IC 102A are electrically connected to respective bond pads 110 on substrate 108 using respective solder traces 104E, F, G, H. In this way, circuitry in first IC 102A is electrically connected to substrate 108, and circuitry in second IC 102B is electrically connected to first IC 102A directly, and substrate 108 through first IC 102A.

As will be appreciated, the configurations and techniques illustrated herein are examples, and other configurations of ICs including metallized castellations formed at perimeters of the ICs and systems including multiple ICs are contemplated and can be formed without departing from the scope of this disclosure. Various examples have been described. These and other examples are within the scope of the following claims.

## Claims

1. An integrated circuit comprising:
a semiconductor substrate defining a perimeter of the integrated circuit and a castellation formed at the perimeter;
a layer including an electrically conductive material formed on a surface of the castellation, wherein the layer including the electrically conductive material is not substantially parallel to adjacent portions of the perimeter of the integrated circuit;
an active area formed in the semiconductor substrate, wherein the active area comprises a plurality of active devices; and
a connecting link electrically connecting the active area and the layer including the electrically conductive material.

2. The integrated circuit of claim 1, wherein an outer surface of the layer including the electrically conductive material substantially reproduces a curvature of the castellation.

3. The integrated circuit of claim 1, wherein the castellation comprises a plurality of castellations, wherein the connecting link comprises a plurality of connecting links, wherein the layer including the electrically conductive material formed on the surface of the castellation comprises a plurality of respective layers including the electrically conductive material, each respective layer being formed on a respective castellation of the plurality of castellations, and wherein at least of the respective layers is not electrically connected to the active area by a connecting link of the plurality of connecting links.

4. The integrated circuit of claim 1, wherein the castellation comprises a plurality of castellations, and wherein each respective castellation of the plurality of castellations includes a layer including an electrically conductive material formed on a respective surface of the respective castellation.

5. A system comprising:
the integrated circuit of any one of claims 1 to 4;
a substrate to which the integrated circuit is mechanically attached, wherein the substrate comprises an electrical connection; and
a solder trace electrically connecting the electrical connection of the substrate and the layer including the electrically conductive material.

6. The system of claim 5, wherein the integrated circuit comprises a first integrated circuit, the semiconductor substrate comprises a first semiconductor substrate, the castellation comprises a first castellation, the active area comprises a first active area, and wherein the substrate comprises a second integrated circuit, the second integrated circuit comprising:
a second semiconductor substrate defining a perimeter of the second integrated circuit and a second castellation formed at the perimeter;
a layer including an electrically conductive material formed on a surface of the second castellation, and wherein the layer including the electrically conductive material is not substantially parallel to adjacent portions of the perimeter of the second integrated circuit;
a second active area formed in the second semiconductor substrate, wherein the second active area comprises a plurality of active devices; and
a connecting link electrically connecting the second active area and the layer including the electrically conductive material, and
wherein the solder trace electrically connects the layer including the electrically conductive material formed on the first castellation and the layer including the electrically conductive material formed on the second castellation.

7. The system of claim 5, wherein the integrated circuit comprises a first integrated circuit, wherein the substrate comprises a second integrated circuit, the second integrated circuit comprising a bond pad formed on a surface of the second integrated circuit, and wherein the solder trace electrically connects the layer including the electrically conductive material formed on the castellation bond pad.

8. The system of claim 5, wherein the substrate comprises a printed board, and wherein the electrical connection comprises a bond pad formed on a surface of the printed board.

9. A method comprising:
forming a plurality of holes in a semiconductor wafer at locations corresponding to a saw street;
metallizing respective walls of the plurality of holes to form respective layers including an electrically conductive material on the respective walls of the plurality of holes, wherein metallizing respective walls of the plurality of holes does not fill the holes with metal;
forming a plurality of active devices in the semiconductor substrate;
electrically connecting the respective layers including the electrically conductive material to respective active devices of the plurality of active devices using a respective connecting link of a plurality of connecting links; and
singulating the semiconductor wafer along the saw street to form a perimeter of the semiconductor substrate comprising a plurality of metallized castellations.

10. The method of claim 9, wherein forming the plurality of active devices comprises forming the plurality of active devices after forming the plurality of holes.
